# EUROPEAN PATENT APPLICATION

(11) **EP 4 593 060 A1**
(43) Date of publication of application: **30.07.2025**
(21) Application number: 24190520.7
(22) Date of filing: 24.07.2024
(51) Int. Cl.: H01L 21/02, H01L 21/762

(54) **STRUCTURES INCLUDING A SEMICONDUCTOR LAYER FORMED BY LATERAL EPITAXIAL GROWTH**

(30) Priority: 24.01.2024 US 202418420998
(71) Applicant: GlobalFoundries U.S. Inc., Malta, NY 12020 (US)
(72) Inventor: Holt, Judson R., Malta, 12020 (US); Mishra, Kaushikee, Malta, 12020 (US); Giewont, Kenneth J., Hopewell Junction, 12533 (US); Manghnani, Mohnish, Malta, 12020 (US); McCutcheon, Jonathan, Malta, 12020 (US); Baars, Peter, 01109 Dresden (DE)
(74) Representative: Grünecker Patent- und Rechtsanwälte PartG mbB

(57) **Abstract**

Structures that include a semiconductor layer formed by lateral epitaxial growth and methods of forming such structures. The structure comprises a first semiconductor layer including a first section and a second section adjacent to the first section, a second semiconductor layer including a section and a semiconductor region that projects from the second section of the first semiconductor layer to the section of the second semiconductor layer, and a dielectric layer disposed between the first section of the first semiconductor layer and the section of the second semiconductor layer. The section and the semiconductor region of the second semiconductor layer comprise one or more single-crystal semiconductor materials.

## Description

### BACKGROUND

The disclosure relates generally to semiconductor devices and integrated circuit fabrication and, in particular, to structures that include a semiconductor layer formed by lateral epitaxial growth and methods of forming such structures.

Solid-phase epitaxy refers to the type of growth when a semiconductor material undergoes a transition from an amorphous phase to a single-crystal phase. Typically, the material is deposited in the amorphous phase on a single-crystal substrate, which has a crystal structure that serves as a template for crystallization during the transition to the single-crystal phase. Lateral solid-phase epitaxy involves the formation of an epitaxial semiconductor material over a dielectric layer. Conventional lateral solid-phase epitaxy processes are limited with respect to the effective distance for crystallization in a horizontal direction over the dielectric layer.

Improved structures that include a semiconductor layer formed by lateral epitaxial growth and methods of forming such structures are needed.

### SUMMARY

In an embodiment of the invention, a structure comprises a first semiconductor layer including a first section and a second section adjacent to the first section, a second semiconductor layer including a section and a semiconductor region that projects from the second section of the first semiconductor layer to the section of the second semiconductor layer, and a dielectric layer disposed between the first section of the first semiconductor layer and the section of the second semiconductor layer. The section and the semiconductor region of the second semiconductor layer comprise one or more single-crystal semiconductor materials.

In an embodiment of the invention, a method comprises forming a first section and a second section of a first semiconductor layer, and forming a second semiconductor layer that includes a section and a semiconductor region that projects from the second section of the first semiconductor layer to the section of the second semiconductor layer. The second section of the first semiconductor layer is adjacent to the first section of the first semiconductor layer, the section of the second semiconductor layer and the semiconductor region of the second semiconductor layer comprise one or more single-crystal semiconductor materials, and a dielectric layer is disposed between the first section of the first semiconductor layer and the section of the second semiconductor layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention.
FIGS. 1-5 are cross-sectional views of a structure at successive fabrication stages of a processing method in accordance with embodiments of the invention.
FIGS. 6-7 are cross-sectional views of a structure at successive fabrication stages of a processing method in accordance with alternative embodiments of the invention.
FIG. 8 is a cross-sectional view of a structure in accordance with alternative embodiments of the invention.
FIGS. 9-10 are cross-sectional views of a structure at successive fabrication stages of a processing method in accordance with alternative embodiments of the invention.
FIG. 11 is a cross-sectional view of a structure in accordance with alternative embodiments of the invention.

### DETAILED DESCRIPTION

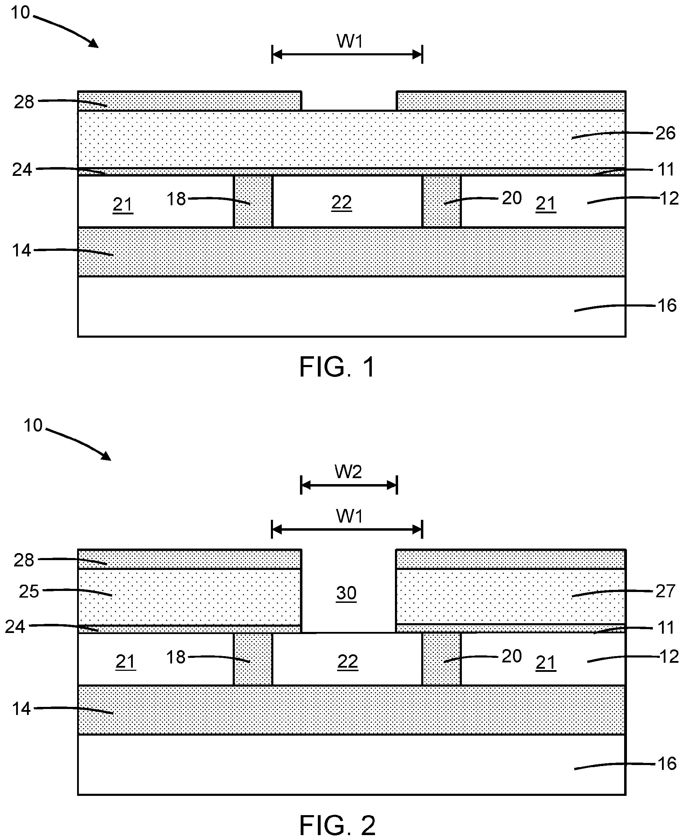

With reference to FIG. 1 and in accordance with embodiments of the invention, a structure 10 may be formed using a silicon-on-insulator substrate that includes a semiconductor layer 12, a buried insulator layer 14, and a semiconductor substrate 16. In an embodiment, the semiconductor layer 12 may be comprised of a semiconductor material, such as single-crystal silicon. The buried insulator layer 14 may be comprised of a dielectric material, such as silicon dioxide, that is an electrical insulator. The semiconductor substrate 16 may be comprised of a semiconductor material, such as single-crystal silicon. The buried insulator layer 14 is disposed between the semiconductor layer 12 and the semiconductor substrate 16. The buried insulator layer 14 has a lower interface with the semiconductor substrate 16 and an upper interface with the semiconductor layer 12. In an embodiment, the semiconductor layer 12 may be significantly thinner than the semiconductor substrate 16. In an embodiment, the semiconductor layer 12 may have a thickness between the upper and lower interfaces in a range of about 30 nanometers to about 300 nanometers.

Shallow trench isolation regions 18, 20 are formed that penetrate through the semiconductor layer 12 to the buried insulator layer 14. The shallow trench isolation regions 18, 20 may be formed by patterning shallow trenches with lithography and etching processes, depositing a dielectric material, such as silicon dioxide, to fill the shallow trenches, and planarizing and/or recessing the dielectric material.

A section 22 of the semiconductor layer 12 is disposed laterally in the space between the shallow trench isolation region 18 and the shallow trench isolation region 20. The section 22 of the semiconductor layer 12 has a width dimension W1 that may be equal to the spacing between the shallow trench isolation region 18 and the shallow trench isolation region 20. The semiconductor layer 12 includes sections 21 adjacent to the section 22 and separated from the section 22 by the shallow trench isolation regions 18, 20.

A dielectric layer 24 is formed as a coating on the top surface 11 of the semiconductor layer 12 and the shallow trench isolation regions 18, 20. The dielectric layer 24 may be comprised of a dielectric material, such as silicon dioxide or silicon nitride, that is an electrical insulator. In an embodiment, the dielectric layer 24 may have a uniform thickness.

A semiconductor layer 26 is formed on the dielectric layer 24 that coats the top surface 11 of the semiconductor layer 26. The semiconductor layer 26 may be comprised of a semiconductor material, such as silicon, silicon-germanium, or germanium, and the semiconductor layer 26 may contain multiple sublayers and/or composition gradients. In an embodiment, the semiconductor layer 26 may be comprised of a semiconductor material that is amorphous, such as amorphous silicon, amorphous silicon-germanium, or amorphous germanium. In an embodiment, the semiconductor layer 26 may be comprised of a different semiconductor material from the semiconductor layer 12. In an embodiment, the semiconductor layer 26 may be comprised of the same semiconductor material as the semiconductor layer 12.

A hardmask layer 28 may be formed on the semiconductor layer 26. The hardmask layer 28, which may be comprised of one or more dielectric materials such as silicon dioxide and/or silicon nitride, is patterned by lithography and etching processes to define an opening that is aligned with a portion of the section 22 of the semiconductor layer 12. The opening in the hardmask layer 28 is narrower than the width dimension W1 of the section 22 of the semiconductor layer 12.

With reference to FIG. 2 in which like reference numerals refer to like features in FIG. 1 and at a subsequent fabrication stage, an opening 30 is patterned in the semiconductor layer 26 by an etching process with reliance upon the hardmask layer 28. The opening 30, which coincides with the opening in the hardmask layer 28, penetrates fully through the semiconductor layer 26 and the dielectric layer 24 to the section 22 of the semiconductor layer 12. The opening 30 may terminate at the top surface 11 of the semiconductor layer 12 or, alternatively, may penetrate to a shallow depth beneath the top surface 11 of the semiconductor layer 12. The opening 30 divides the semiconductor layer 26 into a semiconductor layer 25 and a semiconductor layer 27 defining respective sections of semiconductor material. The semiconductor layers 25, 27 are disposed over the sections 21 of the semiconductor layer 12 and portions of the section 22 of the semiconductor layer 12, and the semiconductor layers 25, 27 extend across the shallow trench isolation regions 18, 20. The opening 30 has a width dimension W2 that is less than a width dimension W1 of the section 22 of the semiconductor layer 12. The opening 30 functions as a seed window that exposes a portion of the section 22 of the semiconductor layer 12.

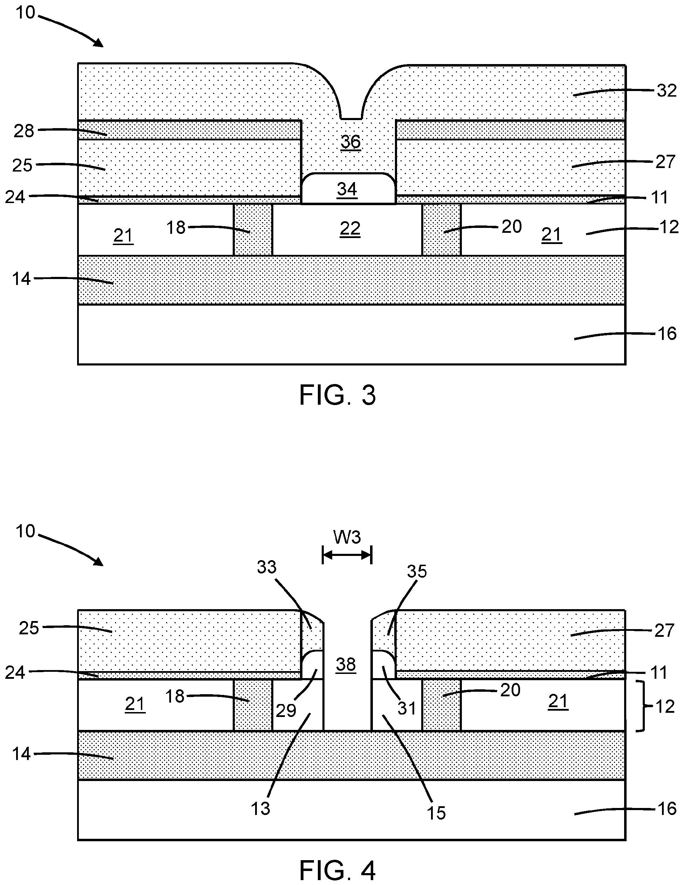

With reference to FIG. 3 in which like reference numerals refer to like features in FIG. 2 and at a subsequent fabrication stage, a semiconductor layer 32 is formed that includes a section 34 that is disposed inside the opening 30 (FIG. 2). The section 34 of the semiconductor layer 32 may be in direct contact with the section 22 of the semiconductor layer 12 at the bottom of the opening 30. The semiconductor layer 32 may be formed by a non-selective epitaxial growth process. The section 34 of the semiconductor layer 32 may grow as single-crystal material, during formation of the semiconductor layer 32, because of the presence of the section 22 of the semiconductor layer 12 that operates as a single-crystal seed during the non-selective epitaxial growth process. Another section 36 of the semiconductor layer 32, which adjoins the section 34 of the semiconductor layer 32, may grow as amorphous material during formation of the semiconductor layer 32. The section 34 of the semiconductor layer 32 projects from the section 22 of the semiconductor layer 12 above the dielectric layer 24.

The semiconductor layer 32 may be comprised of a semiconductor material, such as silicon, silicon-germanium, or germanium, and may contain multiple sublayers and/or composition gradients. In an embodiment, the section 34 of the semiconductor layer 32 may be comprised of a semiconductor material that is single-crystal, such as single-crystal silicon, single-crystal silicon-germanium, or single-crystal germanium. In an embodiment, the section 36 of the semiconductor layer 32 may be comprised of a semiconductor material that is amorphous, such as amorphous silicon, amorphous silicon-germanium, or amorphous germanium. In an embodiment, the semiconductor layer 32 may be comprised of a different semiconductor material from the semiconductor layer 26. In an embodiment, the semiconductor layer 32 may be comprised of the same semiconductor material as the semiconductor layer 26.

A semiconductor material, such as the semiconductor material of the section 34 of the semiconductor layer 32, may be designated single crystal if the crystal lattice structure has long-range order and lacks grain boundaries associated with a polycrystalline semiconductor material. A semiconductor material may be considered to be single crystal even if crystallographic defects, such as dislocations, are incorporated as imperfections. A semiconductor material, such as the semiconductor material of the section 36 of the semiconductor layer 32, may be designated amorphous if long-range order of the crystal lattice structure is absent.

With reference to FIG. 4 in which like reference numerals refer to like features in FIG. 3 and at a subsequent fabrication stage, the section 36 of the semiconductor layer 32, the section 34 of the semiconductor layer 32, and the section 22 of the semiconductor layer 12 are patterned by lithography and anisotropic etching processes to define an opening 38 that may extend to the buried insulator layer 14. The opening 38 divides the section 36 of the semiconductor layer 32 into a semiconductor region 33 and a semiconductor region 35. The opening 38 divides the section 34 of the semiconductor layer 32 into a semiconductor region 29 and a semiconductor region 31. The opening 38 divides the section 22 of the semiconductor layer 12 into a smaller section 13 and a smaller section 15. The patterning of the semiconductor layer 32 reveals the hardmask layer 28, which is removed from the top surface of the semiconductor layers 25, 27 by an etching process. The semiconductor regions 29, 33 and the section 13 of the semiconductor layer 12 are coextensive (i.e., share a boundary) with different portions of the opening 38, and the semiconductor regions 31, 35 and the section 15 of the semiconductor layer 12 are also coextensive with different portions of the opening 38.

The opening 38 has a width dimension W3 that is less than the width dimension W2 of the section 22 of the semiconductor layer 12 and that is less than the width dimension W1 of the opening 30. The semiconductor region 29 is stacked with the section 13 of the semiconductor layer 12 and the semiconductor region 33. The semiconductor region 29 is disposed between the section 13 of the semiconductor layer 12 and the semiconductor region 33. The semiconductor region 31 of the semiconductor layer 32 is stacked with the section 15 of the semiconductor layer 12 and the semiconductor region 35. The semiconductor region 31 is disposed between the section 15 of the semiconductor layer 12 and the semiconductor region 35.

In an alternative embodiment, the opening 38 may extend only through the section 22 of the semiconductor layer 12 and terminate inside the section 22. In another embodiment layer, portions 32 of the section 36 of the semiconductor layer 32 over the hardmask layer 28 may be removed by a polishing process.

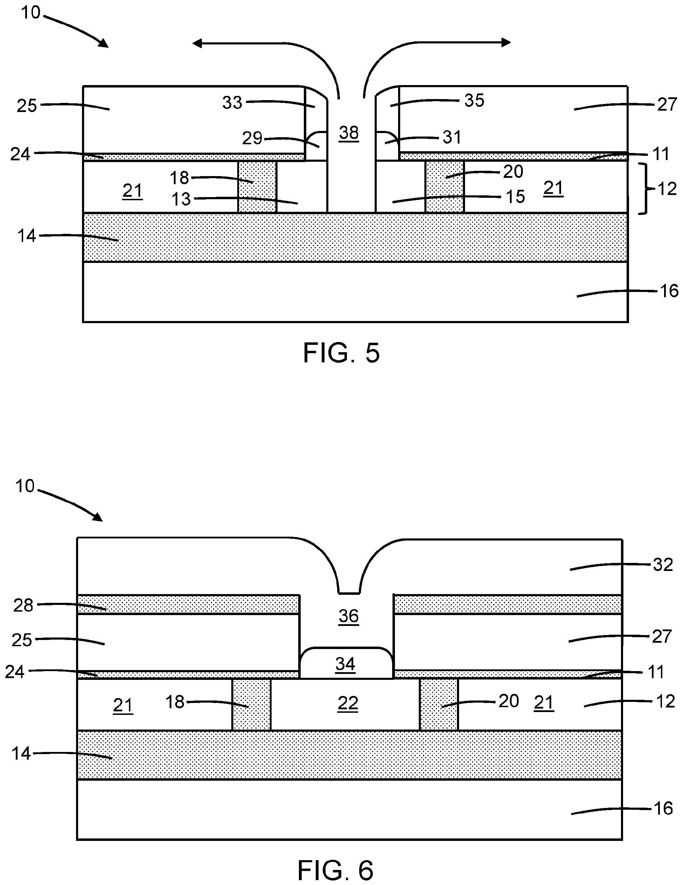

With reference to FIG. 5 in which like reference numerals refer to like features in FIG. 4 and at a subsequent fabrication stage, a lateral solid-phase epitaxy process is used to convert the semiconductor layers 25, 27 and the semiconductor regions 33, 35 from amorphous semiconductor materials to single-crystal semiconductor materials. In an embodiment, the semiconductor layers 25, 27 and the semiconductor regions 33, 35 may be converted to single-crystal semiconductor materials. In embodiments, the lateral solid-phase epitaxy process may include a thermal anneal at a substrate temperature of about 600°C for a given anneal time and in an inert gas environment. In embodiments, the lateral solid-phase epitaxy process may include a rapid thermal anneal.

The semiconductor region 29 is disposed adjacent to an edge of the dielectric layer 24 and the semiconductor region 29 borders (i.e., is coextensive with) a portion of the opening 38. The semiconductor region 31 is disposed adjacent to an edge of the dielectric layer 24 and the semiconductor region 31 borders a portion of the opening 38. The edges of the dielectric layer 24 are formed when the opening 38 is patterned. The semiconductor region 29 provides a single-crystal bridge that connects the section 13 of the semiconductor layer 12 to the semiconductor layer 25 and the semiconductor region 33. The semiconductor region 31 provides a single-crystal bridge that connects the section 15 of the semiconductor layer 12 to the semiconductor layer 27 and the semiconductor region 35.

The semiconductor regions 29, 31 provide respective connectors to the seeds constituted by the sections 13, 15 of the semiconductor layer 12 for enabling the lateral solid-phase epitaxy process. The semiconductor region 29 projects from the section 13 of the semiconductor layer 12 past the edge of the dielectric layer 24 and to the semiconductor layer 25. The semiconductor region 31 projects from the section 15 of the semiconductor layer 12 past the edge of the dielectric layer 24 and to the semiconductor layer 27. The semiconductor layer 25 and the semiconductor region 33 undergo a transition from an amorphous phase to a single-crystal phase based on the crystal structure of the section 13 of the semiconductor layer 12 as enabled by the semiconductor region 29. The semiconductor layer 27 and the semiconductor region 35 undergo a transition from an amorphous phase to a single-crystal phase based on the crystal structure of the section 15 of the semiconductor layer 12 as enabled by the semiconductor region 31. During the solid-phase epitaxy process, an amorphous/crystalline interface advances from each of the semiconductor regions 29, 31 as shown diagrammatically by the curved single-headed arrows.

The single-crystal semiconductor material of the semiconductor layer 25 is separated by a section of the dielectric layer 24 from the single-crystal semiconductor material of the section 21 of the semiconductor layer 12 that is adjacent to the shallow trench isolation region 18. The single-crystal semiconductor material of the semiconductor layer 27 is separated by a section of the dielectric layer 24 from the single-crystal semiconductor material of the section 21 of the semiconductor layer 12 that is adjacent to the shallow trench isolation region 20. In an embodiment, the single-crystal semiconductor material contained in each of the semiconductor layers 25, 27 may extend laterally over the respective underlying sections of the dielectric layer 24 and sections 21 of the semiconductor layer 12 by a distance of greater than or equal to 200 nanometers from the opening 38.

The semiconductor layer 25, the semiconductor region 29, and the semiconductor region 33 may form sections of a seamless semiconductor layer in that the crystal structures of their respective single-crystal semiconductor materials are continuous. In an embodiment, the section 13 of the semiconductor layer 12 may also be included in the sections of the seamless semiconductor layer. The semiconductor layer 27, the semiconductor region 31, and the semiconductor region 35 may form sections of a seamless semiconductor layer in that the crystal structures of their respective single-crystal semiconductor materials are continuous. In an embodiment, the section 15 of the semiconductor layer 12 may also be included in the sections of the seamless semiconductor layer. The pair of seamless semiconductor layers are laterally separated by the intervening opening 38.

The lateral solid-phase epitaxy process may be utilized to form the semiconductor layers 25, 27 as sections of single-crystal semiconductor material that are located on and over sections of the dielectric material of the dielectric layer 24. The lateral solid-phase epitaxy process may exhibit long-range crystallization in which the lateral extent of the single-crystal semiconductor material of the semiconductor layers 25, 27, with limited defects, exceeds the conventional limit for lateral growth over a dielectric layer of less than 200 nanometers.

The structure 10 may be used to form different types of device structures. For example, the structure 10 may be used to form an electro-optical modulator. In an alternative embodiment, the structure 10 may be formed using a bulk substrate instead of a silicon-on-insulator substrate.

With reference to FIG. 6 and in accordance with alternative embodiments, the lateral solid-phase epitaxy process may be performed immediately after forming the semiconductor layer 32. The section 36 of the semiconductor layer 32 and the semiconductor layers 25, 27 are crystallized by the lateral solid-phase epitaxy process. The hardmask layer 28 remains as a dielectric layer disposed between the single-crystal semiconductor material of the semiconductor layers 25, 27 and the single-crystal semiconductor material of the semiconductor layer 32.

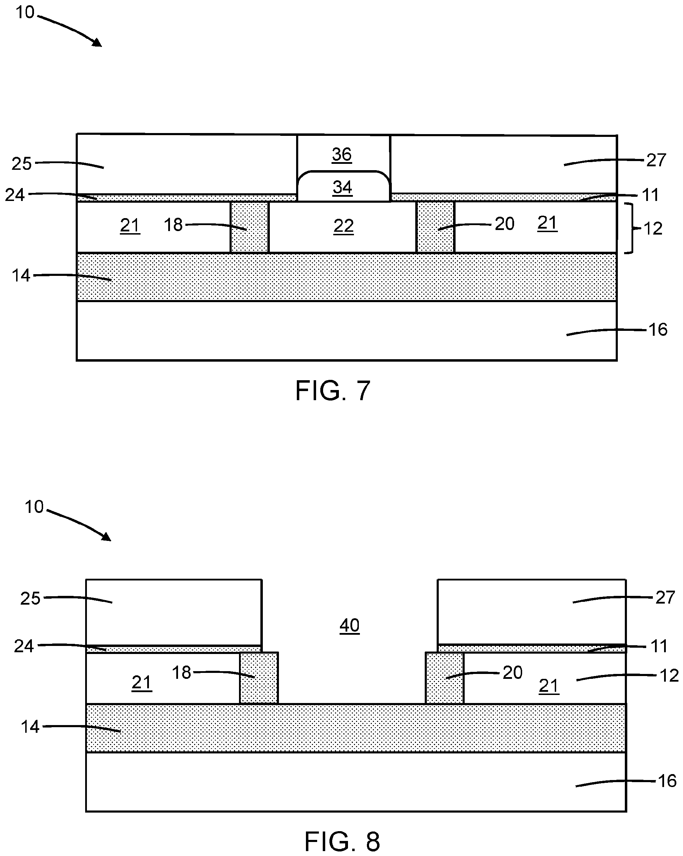

With reference to FIG. 7 in which like reference numerals refer to like features in FIG. 6 and at a subsequent fabrication stage, the semiconductor layer 32 may be planarized and the hardmask layer 28 may be removed such that the section 34 and the portion of the section 36 inside the opening 30 (FIG. 2) remain. In an alternative embodiment, the opening 38 may be formed following planarization.

With reference to FIG. 8 and in accordance with alternative embodiments, the sections 13, 15, the semiconductor regions 29, 31, and the semiconductor regions 33, 35 may be patterned and removed after the performance of the lateral solid-phase epitaxy process to define an opening 40. In an embodiment, the resulting opening 40 may be filled by dielectric material that is electrically insulating.

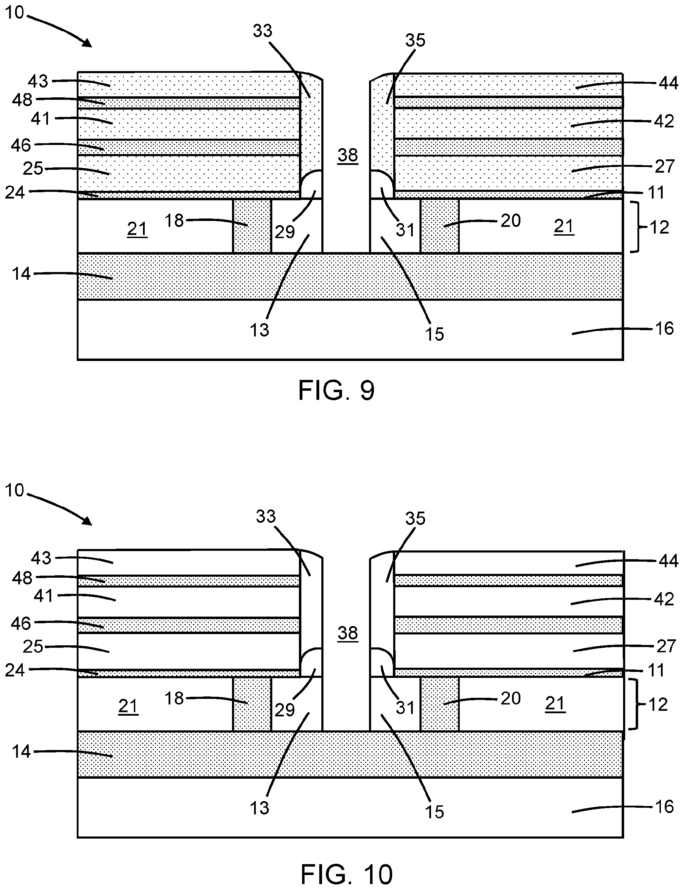

With reference to FIG. 9 and in accordance with alternative embodiments, the structure 10 may include multiple semiconductor layers 41, 43 similar to the semiconductor layer 25, multiple semiconductor layers 42, 44 similar to the semiconductor layer 27, and multiple dielectric layers 46, 48 similar to the dielectric layer 24. A section of the dielectric layer 46 is disposed between the semiconductor layer 25 and the semiconductor layer 41, and a section of the dielectric layer 48 is disposed between the semiconductor layer 41 and the semiconductor layer 43. A layer stack is defined that includes the semiconductor layer 25, the section of the dielectric layer 46, the semiconductor layer 41, the section of the dielectric layer 48, and the semiconductor layer 43. A section of the dielectric layer 46 is disposed between the semiconductor layer 27 and the semiconductor layer 42, and a section of the dielectric layer 48 is disposed between the semiconductor layer 42 and the semiconductor layer 44. A layer stack is defined that includes the semiconductor layer 27, the section of the dielectric layer 46, the semiconductor layer 42, the section of the dielectric layer 48, and the semiconductor layer 44.

In an embodiment, the dielectric layer 24, the dielectric layer 46, and/or the dielectric layer 48 may have different thicknesses. In an embodiment, the dielectric layer 24, the dielectric layer 46, and/or the dielectric layer 48 may have the same thickness. In an embodiment, the semiconductor layer 26, the semiconductor layer 42, and/or the semiconductor layer 44 may have different thicknesses. In an embodiment, the semiconductor layer 26, the semiconductor layer 42, and/or the semiconductor layer 44 may have the same thickness.

The semiconductor layer 32 is deposited and the opening 38 is formed followed by the removal of the hardmask layer 28. The semiconductor region 33, which adjoins each of the semiconductor layers 41, 43, extends from the section 13 past the semiconductor layer 41 to the semiconductor layer 43. The semiconductor region 35, which adjoins each of the semiconductor layers 42, 44, extends from the section 15 past the semiconductor layer 42 to the semiconductor layer 44.

In an embodiment, the semiconductor layer 26, the semiconductor layers 41, 42, and/or the semiconductor layers 43, 44 may be doped during deposition, or post-deposition by ion implantation. In an embodiment, the semiconductor layer 25, the semiconductor layer 27, the semiconductor layer 41, the semiconductor layer 42, the semiconductor layer 43, and/or the semiconductor layer 44 may be doped to have the same conductivity type. In an embodiment, the semiconductor layer 25, the semiconductor layer 27, the semiconductor layer 41, the semiconductor layer 42, the semiconductor layer 43, and/or the semiconductor layer 44 may be doped to have different conductivity types.

With reference to FIG. 10 in which like reference numerals refer to like features in FIG. 9 and at a subsequent fabrication stage, the lateral solid-phase epitaxy process is performed to cause the semiconductor material of the semiconductor regions 33, 35, the semiconductor material of the semiconductor layers 25, 27, the semiconductor material of the semiconductor layers 41, 42, and the semiconductor material of the semiconductor layers 43, 44 to undergo a transition from an amorphous phase to a single-crystal phase. The semiconductor region 29, 31 provide local connectors to the single-crystal seeds defined by the sections 13, 15 of the semiconductor layer 12 for the solid-phase epitaxy process in which the semiconductor materials of the semiconductor regions 33, 35, the semiconductor layers 25, 27, the semiconductor layers 41, 42, and the semiconductor layers 43, 44 are crystallized during the lateral solid-phase epitaxy process. The section 33 defines a pillar of single-crystal semiconductor material that extends past the sections of the dielectric layers 46, 48 and adjoins the semiconductor layers 41, 43 such that the semiconductor region 33 provides an extension of the connection provided by the semiconductor region 29 that enables the lateral solid-phase epitaxy of the amorphous semiconductor material of the semiconductor layers 41, 43. The semiconductor region 35 defines a pillar of single-crystal semiconductor material that extends past the sections of the dielectric layers 46, 48 and adjoins the semiconductor layers 42, 44 such that the semiconductor region 35 provides an extension of the connection provided by the semiconductor region 31 that enables the lateral solid-phase epitaxy of the amorphous semiconductor material of the semiconductor layers 42, 44.

The semiconductor layer 41 and the semiconductor layer 43 are included as additional sections of the seamless semiconductor layer that includes the semiconductor layer 25, the semiconductor region 29, and the semiconductor region 33. The semiconductor layer 42 and the semiconductor layer 44 are included as additional sections of the seamless semiconductor layer that includes the semiconductor layer 27, the semiconductor region 31, and the semiconductor region 35.

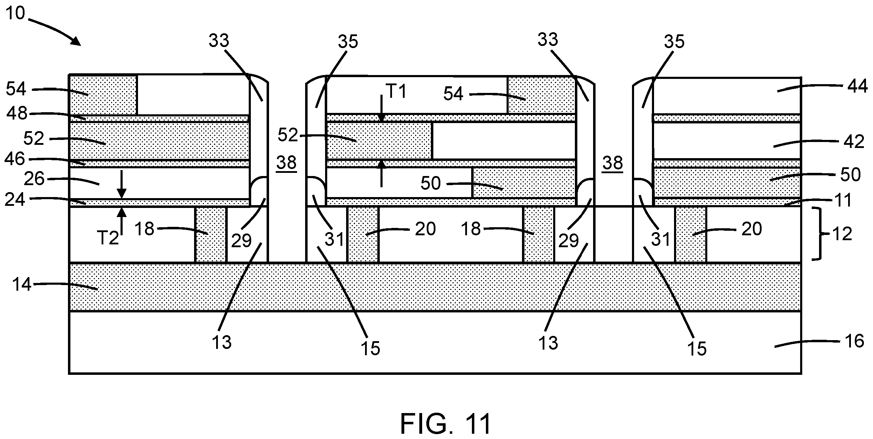

With reference to FIG. 11 and in accordance with alternative embodiments, the portion of the structure 10 including the semiconductor regions 29, 31 may be replicated to provide multiple locations with different sections 13, 15 of the semiconductor layer 12 providing single-crystal seeds for the lateral solid-phase epitaxy process and resulting formation of single-crystal semiconductor material. Dielectric regions 50 may be formed in the semiconductor layer 26, dielectric regions 52 may be formed in the semiconductor layer 42, and dielectric regions 54 may be formed in the semiconductor layer 44. The dielectric regions 50, 52, 54 may be comprised of a dielectric material, such as silicon dioxide, that is an electrical insulator. The dielectric regions 50, 52, 54 may have a thickness T1 that is greater than the thickness T2 of the dielectric layers 24, 46, 48. In an embodiment, the semiconductor layer 26 may have a thickness that is equal to the thickness T1 of the dielectric regions 50, the semiconductor layer 42 may have a thickness that is equal to the thickness T1 of the dielectric regions 52, and the semiconductor layer 44 may have a thickness that is equal to the thickness T1 of the dielectric regions 54.

The dielectric regions 50, 52, 54 may be formed at various different locations within the semiconductor layers 26, 42, 44. In an embodiment, the dielectric regions 50, 52, 54 may be located such that portions of two or more of the semiconductor layers 26, 42, 44 in different levels have an overlapping relationship. In an embodiment, portions of the semiconductor layers 26, 42, 44 in different levels are separated by one or more of the dielectric regions 50, 52, 54.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction perpendicular to the horizontal, as just defined. The term "lateral" refers to a direction within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature with either direct contact or indirect contact.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, structures that include a semiconductor layer formed by lateral epitaxial growth and methods of forming such structures are disclosed. The structure comprises a first semiconductor layer including a first section and a second section adjacent to the first section, a second semiconductor layer including a section and a semiconductor region that projects from the second section of the first semiconductor layer to the section of the second semiconductor layer, and a dielectric layer disposed between the first section of the first semiconductor layer and the section of the second semiconductor layer. The section and the semiconductor region of the second semiconductor layer comprise one or more single-crystal semiconductor materials.

The following embodiments are explicitly disclosed.
Embodiment 1: A structure, comprising:
   a first semiconductor layer including a first section and a second section adjacent to the first section;
   a second semiconductor layer including a first section and a semiconductor region that projects from the second section of the first semiconductor layer to the first section of the second semiconductor layer, and the first section and the semiconductor region of the second semiconductor layer comprising one or more single-crystal semiconductor materials; and a first dielectric layer disposed between the first section of the first semiconductor layer and the first section of the second semiconductor layer.
   In some illustrative examples herein, the structure may further comprise a dielectric region in a portion of the second section of the second semiconductor layer.
Embodiment 2: The structure of embodiment 1, further comprising:
   a shallow trench isolation region disposed between the first section of the first semiconductor layer and the second section of the first semiconductor layer.
Embodiment 3: The structure of embodiment 1 or 2, wherein the first dielectric layer is disposed over the first section of the first semiconductor layer and beneath the first section of the second semiconductor layer, and the first dielectric layer extends across the shallow trench isolation region.
Embodiment 4:
   The structure of one of embodiments 1 to 3, wherein the first dielectric layer extends over a portion of the second section of the first semiconductor layer.
Embodiment 5: The structure of one of embodiments 1 to 4, preferably of embodiment 2, further comprising: an opening.
   In some illustrative examples herein, the opening may penetrate at least partially through the first semiconductor layer and through the second semiconductor layer, wherein the second section of the first semiconductor layer is laterally disposed between the opening and the shallow trench isolation region.
   Additionally or alternatively, the opening may penetrate through the second semiconductor layer, wherein the semiconductor region of the second semiconductor layer is coextensive with the opening.
Embodiment 6: The structure of embodiment 5, further comprising:
   a second dielectric layer,
   wherein the first section of the first semiconductor layer and the second section of the first semiconductor layer are disposed on the second dielectric layer, and the opening penetrates fully through the first semiconductor layer to the second dielectric layer.
Embodiment 7:
   The structure of embodiment 5 or 6, wherein the semiconductor region is coextensive with a portion of the opening.
Embodiment 8:
   The structure of one of embodiments 1 to 7, wherein the semiconductor region of the second semiconductor layer projects from the second section of the first semiconductor layer above the first dielectric layer.
Embodiment 9:
   The structure of one of embodiments 1 to 8, further comprising:
   a second dielectric layer over the first section of the second semiconductor layer,
   wherein the second semiconductor layer includes a second section over the second dielectric layer, and the second section of the second semiconductor layer comprises a single-crystal semiconductor material.
   In some illustrative examples comprising a direct or indirect combination of embodiment 9 with embodiment 6, the second dielectric layer of embodiment 9 may be considered identical with the second dielectric layer in embodiment 6.
Embodiment 10:
   The structure of embodiment 9, wherein the second dielectric layer is disposed between the first section of the second semiconductor layer and the second section of the second semiconductor layer.
Embodiment 11: The structure of embodiment 9 or 10, wherein the semiconductor region of the second semiconductor layer adjoins a side edge of the second section of the second semiconductor layer.
Embodiment 12:
   The structure of one of embodiments 9 to 11, further comprising:
   an opening that penetrates through the second semiconductor layer,
   wherein the semiconductor region of the second semiconductor layer is coextensive with the opening.
   In some illustrative examples comprising a direct or indirect combination of embodiment 12 with embodiment 5, the opening of embodiment 12 may be considered identical with the opening in embodiment 5.
Embodiment 13:
   The structure of embodiment 12, wherein the semiconductor region of the second semiconductor layer is disposed between the first section of the second semiconductor layer and the opening.
Embodiment 14:
   The structure of embodiment 12 or 13, wherein the semiconductor region of the second semiconductor layer is disposed between the second section of the second semiconductor layer and the opening.
Embodiment 15: The structure of one of embodiments 12 to 14, wherein the second section of the first semiconductor layer is disposed between the first section of the first semiconductor layer and the opening.
Embodiment 16:
   The structure of one of embodiments 9 to 15, further comprising:
   a dielectric region in a portion of the second section of the second semiconductor layer.
Embodiment 17:
   The structure of one embodiments 1 to 16, wherein the first section of the second semiconductor layer extends laterally over the first dielectric layer by a distance of greater than or equal to 200 nanometers.
Embodiment 18:
   A method comprising:
   forming a first section and a second section of a first semiconductor layer, wherein the second section is adjacent to the first section; and
   forming a second semiconductor layer that includes a section and a semiconductor region that projects from the second section of the first semiconductor layer to the section of the second semiconductor layer, wherein the section of the second semiconductor layer comprised a single-crystal semiconductor materials, the semiconductor region of the second semiconductor layer comprises a single-crystal semiconductor material, and a dielectric layer is disposed between the first section of the first semiconductor layer and the section of the second semiconductor layer.
Embodiment 19:
   The method of embodiment 18, wherein forming the second semiconductor layer that includes the section and the semiconductor region that projects from the second section of the first semiconductor layer to the section of the second semiconductor layer comprises:
   forming an amorphous semiconductor layer over the dielectric layer; and
   performing a solid-phase epitaxy process to convert the amorphous semiconductor layer to the single-crystal semiconductor material of the section of the second semiconductor layer.
Embodiment 20:
   The method of embodiment 18 or 19, wherein the semiconductor region of the second semiconductor layer connects the section of the second semiconductor layer to the amorphous layer as a seed for the solid-phase epitaxy process.
Embodiment 21:
   The method of one of embodiments 18 to 20, wherein the structure of one of embodiments 1 to 17 is formed.

## Claims

1. A structure comprising:
a first semiconductor layer including a first section and a second section adjacent to the first section;
a second semiconductor layer including a first section and a semiconductor region that projects from the second section of the first semiconductor layer to the first section of the second semiconductor layer, and the first section and the semiconductor region of the second semiconductor layer comprising one or more single-crystal semiconductor materials; and
a first dielectric layer disposed between the first section of the first semiconductor layer and the first section of the second semiconductor layer.

2. The structure of claim 1, further comprising:
a shallow trench isolation region disposed between the first section of the first semiconductor layer and the second section of the first semiconductor layer.

3. The structure of claim 2, wherein the first dielectric layer is disposed over the first section of the first semiconductor layer and beneath the first section of the second semiconductor layer, and the first dielectric layer extends across the shallow trench isolation region, wherein the first dielectric layer preferably extends over a portion of the second section of the first semiconductor layer.

4. The structure of claim 2 or 3, further comprising:
an opening that penetrates at least partially through the first semiconductor layer and through the second semiconductor layer, the semiconductor region preferably being coextensive with a portion of the opening
wherein the second section of the first semiconductor layer is laterally disposed between the opening and the shallow trench isolation region.

5. The structure of claim 4, further comprising:
a second dielectric layer,
wherein the first section of the first semiconductor layer and the second section of the first semiconductor layer are disposed on the second dielectric layer, and the opening penetrates fully through the first semiconductor layer to the second dielectric layer.

6. The structure of one of claims 1 to 5, wherein the semiconductor region of the second semiconductor layer projects from the second section of the first semiconductor layer above the first dielectric layer, and/or wherein the first section of the second semiconductor layer extends laterally over the first dielectric layer by a distance of greater than or equal to 200 nanometers.

7. The structure of one of claims 1 to 6, further comprising:
a second dielectric layer over the first section of the second semiconductor layer,
wherein the second semiconductor layer includes a second section over the second dielectric layer, and the second section of the second semiconductor layer comprises a single-crystal semiconductor material.

8. The structure of claim 7, wherein the second dielectric layer is disposed between the first section of the second semiconductor layer and the second section of the second semiconductor layer.

9. The structure of claim 7 or 8, wherein the semiconductor region of the second semiconductor layer adjoins a side edge of the second section of the second semiconductor layer.

10. The structure of one of claims 7 to 9, further comprising:
an opening that penetrates through the second semiconductor layer,
wherein the semiconductor region of the second semiconductor layer is coextensive with the opening.

11. The structure of claim 10, wherein at least one of:
the semiconductor region of the second semiconductor layer is disposed between the first section of the second semiconductor layer and the opening;
the semiconductor region of the second semiconductor layer is disposed between the second section of the second semiconductor layer and the opening; and
the second section of the first semiconductor layer is disposed between the first section of the first semiconductor layer and the opening.

12. The structure of one of claims 7 to 11, further comprising:
a dielectric region in a portion of the second section of the second semiconductor layer.

13. A method, comprising:
forming a first section and a second section of a first semiconductor layer, wherein the second section is adjacent to the first section; and
forming a second semiconductor layer that includes a section and a semiconductor region that projects from the second section of the first semiconductor layer to the section of the second semiconductor layer, wherein the section of the second semiconductor layer comprised a single-crystal semiconductor materials, the semiconductor region of the second semiconductor layer comprises a single-crystal semiconductor material, and a dielectric layer is disposed between the first section of the first semiconductor layer and the section of the second semiconductor layer.

14. The method of claim 13, wherein forming the second semiconductor layer that includes the section and the semiconductor region that projects from the second section of the first semiconductor layer to the section of the second semiconductor layer comprises:
forming an amorphous semiconductor layer over the dielectric layer; and
performing a solid-phase epitaxy process to convert the amorphous semiconductor layer to the single-crystal semiconductor material of the section of the second semiconductor layer.

15. The method of claim 13 or 14, wherein the semiconductor region of the second semiconductor layer connects the section of the second semiconductor layer to the amorphous layer as a seed for the solid-phase epitaxy process.
